(19) Europäisches Patentamt
European Patent Office
Office européen des brevets

(11) Veröffentlichungsnummer: **0 170 309**
**B1**

(12) # EUROPÄISCHE PATENTSCHRIFT

(45) Veröffentlichungstag der Patentschrift: **12.09.90**

(51) Int. Cl.[5]: **C 30 B 15/00**, C 30 B 29/28

(21) Anmeldenummer: **85201033.9**

(22) Anmeldetag: **28.06.85**

(54) **Einkristall auf Basis von Seltenerdmetall-Gallium-Granat.**

(30) Priorität: **04.07.84 DE 3424487**

(43) Veröffentlichungstag der Anmeldung:
**05.02.86 Patentblatt 86/06**

(45) Bekanntmachung des Hinweises auf die Patenterteilung:
**12.09.90 Patentblatt 90/37**

(84) Benannte Vertragsstaaten:
**CH DE FR GB IT LI**

(56) Entgegenhaltungen:

**AIP CONFERENCE PROCEEDINGS, Nr. 5, (Part 1), 1971, Seiten 700-703, American Institute of Physics, New York, US; L. SUCHOW et al.: "Magnetic behavior of garnets with rare earth ions on both dodecahedral and octahedral sites"**

**Die Akte enthält technische Angaben, die nach dem Eingang der Anmeldung eingereicht wurden und die nicht in dieser Patentschrift enthalten sind.**

(73) Patentinhaber: **Philips Patentverwaltung GmbH
Wendenstrasse 35 Postfach 10 51 49
D-2000 Hamburg 1 (DE)**
(84) **DE**

(73) Patentinhaber: **N.V. Philips' Gloeilampenfabrieken
Groenewoudseweg 1
NL-5621 BA Eindhoven (NL)**
(84) **CH FR GB IT LI**

(72) Erfinder: **Mateika, Dieter, Dr.
Seerosenstrasse 16
D-2087 Ellerbek (DE)**
Erfinder: **Rusche, Christian
Burdiekstrasse 34
D-2200 Elmshorn (DE)**

(74) Vertreter: **Nehmzow-David, Fritzi-Maria et al
Philips Patentverwaltung GmbH Wendenstrasse 35 Postfach 10 51 49
D-2000 Hamburg 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 170 309 B1

Courier Press, Leamington Spa, England.

(56) Entgegenhaltungen
JOURNAL OF CRYSTAL GROWTH, Band 20, Nr. 1, 1973, Seiten 1-5, North-Holland Publishing Co., NL; C.D. BRANDLE et al.: "Crystal stoichiometry and growth of rare-earth garnets containing scandium"

Journal of Solid State Chemistry, 8 (1973), seiten 357-359

**Beschreibung**

Einkristall auf Basis von Seltenerdmetall-Gallium-Granat

Die Erfindung bezieht sich auf einem Einkristall auf der Basis von Seltenerdmetall-Gallium-Granat, ausgenommen $\{La_{2,6}Yb_{0,4}\}[Yb_2](Ga_3)O_{12}$.

Derartige Einkristalle werden üblicherweise als Stäbe aus einer Schmelze gezüchtet, z.B. nach einem in "Solid State Communications" *2* (1964), Seite 229 bis 231 beschriebenen Verfahren. Anschließend werden von diesen Stäben Einkristallscheiben gewünschter Dicke abgeschnitten.

Nichtmagnetische Granateinkristall-Scheiben werden vorzugsweise als Substrate verwendet, auf denen in Flüssigphasen- oder Gasphasen-Epitaxieprozessen einkristalline Schichten für die unterschiedlichsten Anwendungszwecke erzeugt werden.

Einkristalline epitaktisch erzeugte Schichten können nur dann mit der erforderlichen Störungsfreiheit und Perfektion auf dem vorgebenen Substrat aufwachsen, wenn Substrat und epitaktische Schicht nahezu die gleiche kristallographische Gitterkonstante besitzen. Gadolinium-Gallium-Granat $Gd_3Ga_5O_{12}$ beispielsweise hat eine Gitterkonstante $a_0$ von 1,238 nm, ist also für epitaktische Schichten mit etwa entsprechender Gitterkonstante geeignet.

Um nichtmagnetische Granateinkristalle größerer Gitterkonstanten zuer erhalten, ist in der Technik bereits nach Wegen gesucht worden. So ist aus DE—PS 24 34 251 ein Einkristall auf der Basis von Gadolinium/Samarium/Neodym-Gallium-Granat bekannt, bei dem durch gekoppelten Ersatz der Kationen im Granatgitter durch kleinere oder größere zwei- oder vier-wertige bzw. ein- oder fünf-wertige Kationen eine lineare Vergrößerung oder Verkleinerung der Gitterkonstante $a_0$ im Bereich von $a_0=1,238$ nm ($Gd_3Ga_5O_{12}$) bis $a_0=1,2569$ nm ($Nd_{2,6}Sr_{0,4}Ga_{4,6}Zr_{0,4}O_{12}$) erreicht werden kann.

Für bestimmte Anwendungsfälle werden nichtmagnetische Granateinkristallsubstrate mit noch größeren Gitterkonstanten im Bereich $a_0=1,260$ bis 1,300 nm benötigt, z.B. für epitaktische Schichten der Zusammensetzung $Cd_{1-x}Hg_xTe$, die als Infrarotdetektoren angewendet werden oder wenn das Granatsubstrat als Wirtgitter für den Einbau von Fremdatomen, die einen Lasereffekt zeigen, wie z.B. $Nd^{3+}$, $Er^{3+}$ und/oder $Cr^{3+}$ für die Herstellung von Festkörperlasern benutzt werden soll.

Nichtmagnetische Granatsubstrate mit Gitterkonstanten $a_0$ im Bereich von 1,250 bis 1,290 nm sind aus Journal of Solid State Chemistry *8* (173), Seiten 357 bis 359 bekannt; hier sind substituierte Gallium-Granate mit $La^{3+}$ auf dem Dodekaederplatz im Granatgitter beschrieben, die in Sinterprozessen (Feststoffreaktionen) unterhalb der Schmelztemperaturen bergestellt wurden. Es ist anzumerken, daß aus Journal of Solid State Chemistry *8* (1973), Seiten 357 bis 359 die Zusammensetzung $\{La_{2,6}Yb_{0,4}\}[Yb_2](Ga_3)O_{12}$ bekannt ist, die jedoch nur als Sinterkörper hergestellt wurde.

Der Erfindung liegt die Aufgabe zugrunde, Zusammensetzungen für nichtmagnetische Granate mit Gitterkonstanten im Bereich von $a_0=1,260$ bis 1,300 nm anzugeben, die kongruent schmelzen, aus deren Schmelzen als Einkristalle züchtbar sind.

Diese Aufgabe wird erfindungsgemäß dadurch gelöst, daß der Einkristall ein Mischkristall der allgemeinen Formel

$A_{3-x-y}B_xC_yD_{2-z}E_zGa_3O_{12}$ ist, worin

$A=La^{3+}$, $Pr^{3+}$, $Nd^{3+}$, $Sm^{3+}$ und/oder $Eu^{3+}$

$B=Yb^{3+}$, $Er^{3+}$ und/oder $Y^{3+}$

$C=Er^{3+}$, $Ho^{3+}$, $Y^{3+}$, $Dy^{3+}$, $Tb^{3+}$, $Gd^{3+}$, $Eu^{3+}$, $Sm^{3+}$, $Nd^{3+}$, $Ca^{2+}$, $Pr^{3+}$, $Ce^{3+}$, $Sr^{2+}$ und/oder binäre Mischungen dieser Ionen

$D=Yb^{3+}$, $Er^{3+}$

$E=Si^{4+}$, $Ge^{4+}$, $Al^{3+}$, $Ni^{3+}$, $Ti^{4+}$, $Co^{3+}$, $Cr^{3+}$, $Ga^{3+}$, $Mn^{3+}$, $Hf^{4+}$, $Mg^{2+}$, $Zr^{4+}$, $Cu^{2+}$, $Sc^{3+}$, $In^{3+}$, $Mn^{2+}$, $Lu^{3+}$, $Ce^{4+}$ und/oder binäre Mischungen dieser Ionen

mit $0 \leq x \leq 2,0$

$0 \leq y \leq 1,8$

$0 \leq z \leq 0,4$.

Der Erfindung liegt die Erkenntnis zugrunde, daß Granateinkristalle mit Gitterkonstanten im Bereich von $a_0=1,260$ bis 1,300 nm erhalten werden können, wenn Mischkristalle gezüchtet werden, bei denen auf den Dodekaederplätzen zwei- und/oder drei-wertige Kationen mit Radien im Bereich von 0,0985 bis 0,125 nm und auf den Oktaederplätzen neben Ytterbium und/oder Erbium zwei- drei- und/oder vier-wertige Kationen mit Radien im Bereich von 0,04 bis 0,089 nm neben Gallium auf dem Tetraederplatz vorhanden sind, wobei Konzentration, Wertigekeit und Polarisierung der Kationen sowie die Deformation des Gitterplatzes zusätzliche zu den Radienverhältnissen der Kationen Parameter sind, die die Entstehung der Granatphase beeinflussen.

Nach einer vorteilhaften Weiterbildung der Erfindung entspricht die Schmelzzusammensetzung des Einkristalls der Formel

$$Sm_2Yb_{2,75}Al_{0,25}Ga_3O_{12};$$

ein solcher Einkristall hat eine Gitterkonstante $a_0=1,2613$ nm.

Nach einer weiteren vorteilhaften Ausgestaltung der Erfindung entspricht die

Schmelzzusammensetzung des Einkristalls der Formel

$$La_2Yb_{2,8}Al_{0,176}Cr_{0,024}Ga_3O_{12};$$

ein solcher Einkristall hat eine Gitterkonstante $a_0=1,2868$ nm.

Nach einer weiteren vorteilhaften Ausgestaltung der Erfindung entspricht die Schmelzzusammensetzung des Einkristalls der Formel

$$La_{2,096}Er_{0,904}Yb_{1,839}Ga_{3,161}O_{12};$$

ein solcher Einkristall hat eine Gitterkonstante $a_0=1,2907$ nm.

Nach einer weiteren Ausgestaltung der Erfindung entspricht die Schmelzzusammensetzung des Einkristalls der Formel

$$La_{2,17}Nd_{0,42}Yb_{2,31}Al_{0,1}Ga_3O_{12};$$

ein solcher Einkristall hat eine Gitterkonstante $a_0=1,2938$ nm.

Nach einer weiteren vorteilhaften Ausgestaltung der Erfindung entspricht die Schmelzzusammensetzung des Einkristalls der Formel

$$La_{2,3}Er_{2,7}Ga_3O_{12};$$

ein solcher Einkristall hat eine Gitterkonstante $a_0=1,2965$ nm.

Ein Verfahren zur Herstellung eines Einkristalls der oben beschriebenen Art ist dadurch gekennzeichnet, daß die Ausgangssubstanzen für den Einkristall zunänst trocken verpreßt und in einer Sauerstoffatmosphäre gesintert werden, daß der Sinterkörper zur Herstellung eines Einkristalls nach dem Czoschralksi-Verfahren in einer abgeschlossenen Kristallziehapparatur aufgeschmolzen und daß aus dieser Schmelze ein Einkristall mit Hilfe eines Keimkristalls gezogen wird, wobei vorzugsweise unter einer Gasatmosphäre bestehend aus 50% $N_2$ und 50% $CO_2$ oder 98% $N_2$ und 2% $O_2$ gezogen wird.

Mit diesem Verfahren ist es möglich, einkristalline Granatmischkristalle mit Gitterkonstanten $a_0$ im Bereich von 1,260 bis 1,300 nm zu ziehen, wobei die Abweichung $\Delta a_0$ des Wertes für die Gitterkonstanten zwischen Wachstumsbeginn und Wachstumsende nicht mehr als $8\times10^{-4}$ nm, vorzugsweise $4\times10^{-4}$ nm beträgt.

Einkristalle der oberen beschriebenen Art sind vorzugsweise verwendbar als Wirtgitter für den Einbau von Fremdatomen, die einen Lasereffekt zeigen oder als Substrate für epitaktische Schichten, die als Infrarotdetektoren eingesetzt werden.

Anhand der Zeichung werden Ausführungbeispiele der Erfindung beschrieben und in ihrer Wirkungsweise erläutert. Es zeigen:

Figur 1 Phasendiagramm mit Stabilitätsbereich des Mischkristallsystems

$$\{La_{3-x-y}Yb_xEr_y\}[Yb_{2-z}Al_z]\ (Ga_3)O_{12}$$

mit $0\leq x\leq 1,9$
$0\leq y\leq 1,75$
$0\leq z\leq 0,3$

Figur 2 Phasendiagramm mit Stabilitätsbereich des Mischkristallsystems

$$\{La_{3-x-y}Yb_xY_y\}[Yb_{2-z}Al_z](Ga_3)O_{12}$$

mit $0\leq x\leq 1,9$
$0\leq y\leq 1,6$
$0\leq z\leq 0,3$

Figur 3 Phasendiagramm mit Stabilitätsbereich des Mischkristallsystems

$$\{La_{3-x-y}Yb_xGd_y\}[Yb_{2-z}Al_z](Ga_3)O_{12}$$

mit $0\leq x\leq 1,9$
$0\leq y\leq 1,2$
$0\leq z\leq 0,3$

Figur 4 Phasendiagramm mit Stabilitätsbereich des Mischkristallsystems

$$\{La_{3-x-y}Yb_xNd_y\}[Yb_{2-z}Al_z](Ga_3)O_{12}$$

mit $0 \leq x \leq 1{,}9$
$0 \leq y \leq 1{,}4$
$0 \leq z \leq 0{,}3$.

Zur Beeinflussung der Gitterkonstanten $a_0$ von Granatmischkristallen sind vorzugsweise die Ionen der Seltenerdmettale für den Einbau auf dem Dodekaederplatz (entspricht den geschweiften Klammern in den Mischkristallsystemen der Figurenbeschreibung) und dem Oktaederplatz (entspricht der eckigen Klammern in den Mischkrstallsystemen der Figurenbeschreibung) sowie $Ga^{3+}$ auf dem Tetraederplatz (entspricht den runden Klammern in den Mischkristallsystemen der Figurenbeschreibung) geeignet.

Voraussetzung für eine Einkristallzüchtung ist dabei die Kenntnis der Stabilitätsgrenzen hinsichtlich der chemischen Zusammensetzung der Mischkristalle. In den Figuren 1 bis 4 sind Ergebnisse von Phasenanalysen von Mischkristallen gemäß der Erfindung dargestellt. Das Mischkristallsystem

$$\{La_{3-x-y}Yb_xEr_y\}[Yb_{2-z}Al_z](Ga_3)O_{12}$$

ist in Figure 1 dargestellt. Auf den Seiten des Dreiecks sind die Konzentrationen der Kationen auf dem Dodekaederplatz in Formeleinheiten aufgetragen. Die Kreuze kennzeichnen die Schmelzzusammensetzungen, die ausschließlich eine Granatphase bilden. Die Ziffern an den Kreuzen geben die Konzentrationen der Kationen auf dem Oktaederplatz an (0 entspricht z=0; 1 entspricht z=0,1; 2 entspricht z=0,2; 3 entspricht z=0,3).

Die Konzentration der Galliumionen betrug bei allen Proben 3 Formeleinheiten. Auf der linken Seite des Konzentrationsdreiecks sind die Mischkristallzusammensetzungen mit Lanthan und Ytterbium auf dem Dodekaederplatz aufgetragen. Der Stabilitätsbereich dieser Mischkristalle liegt zwischen $0{,}4 \leq x \leq 1{,}9$ mit y=0. Die Mischkristallzusammensetzungen mit Lanthan und Erbium sind auf der rechten Seite des Dreiecks aufgetragen. Der Stabilitätsbereich ist etwas kleiner ($0{,}5 \leq y \leq 1$, mit x=0). Zwischen beiden Granatmischkristallreihen gibt es eine vollständige Mischbarkeit. Die Stabilitätsgrenzen dieser Mischkristalle werden durch die obere und untere Begrenzungslinie wiedergeben.

Mit abnehmendem Lanthangehalt in den Mischkristallen verringert sich der mittlere Ionenradius des Dodekaederplatzes. Als Folge der Radienänderung wird eine Anpassung des mittleren Ionenradius des Oktaederplatzes erzwungen. Die Anpassung erfolgt in diesem Beispiel durch partiellen Einbau von Aluminium, das einen Ionenradius von 0,0539 nm hat. Die Zunahme der Aluminiumkonzentration auf dem Oktaederplatz wird durch Ziffern 0 bis 3 wiedergegeben.

In Figur 2 ist das Mischkristallsystem

$$\{La_{3-x-y}Yb_xY_y\}[Yb_{2-z}Al_z](Ga_3)O_{12}$$

dargestellt.

Hier ist Erbium durch das größere Seltenerdmetall-Ion Yttrium (Ionenradius=0,1019 nm) ersetzt. Die Mischkristallzusammensetzungen Lanthan-Yttrium sind auf der rechten Seite des Phasendiagramms aufgetragen. Ihr Stabilitätsbereich ist im Vergleich zu der Lanthan-Ytterbium-Mischkristallreihe noch kleiner geworden. Zwischen beiden Mischkristallreihen gibt es wiederum eine vollständige Mischbarkeit.

In den Figuren 3 und 4 sind die Mischkristallsysteme

$$\{La_{3-x-y}Yb_xGd_y\}[Yb_{2-z}Al_z](Ga_3)O_{12}$$

und

$$\{La_{3-x-y}Yb_xNd_y\}[Yb_{2-z}Al_z](Ga_3)O_{12}$$

dargestellt.

Wird das Seltenerdmetall-Ion Yttrium durch größere Ionen wie Gadolinium (Ionenradius=0,1061 nm) oder Neodym (Ionenradius=0,112 nm) erzetzt, dann sind die Mischkristalle mit Lanthan (vergleiche rechte Seite des Phasendiagramms) nicht mehr stabil. Die Stabilitätsgrenze der Lanthan-Seltenerdmetall-Mischkristallreihe verschiebt sich mit zunehmendem Ionenradius des Substituenten von der rechten Konzentrationsseite in das innere Feld des Phasendiagramms. Gleichzeitig öffnet sich das Stabilitätsgebiet dieser Mischkristalle etwas zu kleineren Lanthan-Konzentrationen hin, wie es das Beispiel in Figur 4 zeigt. Alle Mischkristalle innerhalb des Phasendiagramms enthalten auf dem Dodekaederplatz neben Lanthan zusätzlich ein kleines Ion, z.B. Ytterbium, und ein größeres Ion, wie z.B. Neodym oder Gadolinium, deren Radien zwischen den Radien für Ytterbium und Lanthan liegen. Die Anpassung des mittleren Ionenradius des Oktaederplatzes erfolgt in den Beispielen gemäß den Figuren 3 und 4 wieder durch Aluminium.

Lanthan kann ganz oder teilweise durch Praseodym (Ionenradius=0,1137 nm), Neodym (Ionenradius=0,112 nm), Samarium (Ionenradius=0,1087 nm) und/oder Europium (Ionenradius=0,1073 nm) ersetzt werden. Das Ytterbium auf dem Dodekaederplatz kann ganz oder teilweise durch Erbium oder Yttrium ersetzt werden. Als weitere Substituenten für die Ionen auf dem Dodekaederplatz sind die Ionen $Ho^{3+}$, $Dy^{3+}$, $Tb^{3+}$, $Eu^{3+}$, $Sm^{3+}$, $Ca^{2+}$, und $Sr^{2+}$ geeignet. Beispiele für derartige Mischkristalle sind in der

nachfolgenden Tabelle 1 aufgeführt.

TABELLE 1:
Substituenten für Lanthan

| Schmelzzusammensetzungen | Gitterkonstante [nm] (berechnet) |
|---|---|
| $\{La_{2,143}Dy_{0,857}\}[Yb_{1,839}Ga_{0,161}](Ga_3)O_{12}$ | 1,2907 |
| $\{La_{1,825}Tb_{1,175}\}[Yb_{1,73}Mg_{0,135}Zr_{0,135}](Ga_3)O_{12}$ | 1,2886 |
| $\{La_1Eu_1Yb_1\}[Yb_{1,8}Al_{0,2}](Ga_3)O_{12}$ | 1,2768 |
| $\{La_{1,95}Gd_{0,32}Yb_{0,63}Ca_{0,1}\}[Yb_{1,8}Ce_{0,1}Al_{0,1}](Ga_3)O_{12}$ | 1.2886 |
| $\{Pr_{2,387}La_{0,1}Yb_{0,513}\}[Yb_2](Ga_3)O_{12}$ | 0,2876 |
| $\{Pr_{2,055}Gd_{0,945}\}[Yb_2](Ga_3)O_{12}$ | 1,2878 |
| $\{Pr_{2,511}Er_{0,1}Yb_{0,389}\}[Yb_{1,991}Ga_{0,009}](Ga_3)O_{12}$ | 1,2875 |
| $\{Pr_{2,423}Nd_{0,1}Yb_{0,477}\}[Yb_2](Ga_3)O_{12}$ | 0,2876 |
| $\{La_{2,3}Ce_{0,3}Yb_{0,4}\}[Yb_2](Ga_3)O_{12}$ | 1,2964 |
| $\{Sm_2Yb_1\}[Yb_{1,75}Al_{0,25}](Ga_3)O_{12}$ | 1,2629 |
| $\{Eu_{1,5}Yb_{1,5}\}[Yb_{1,0}In_{1,0}](Ga_3)O_{12}$ | 1,2580 |

Zur Anpassung des mittleren Ionenradius des Oktaederplatzes können anstelle von Aluminium auch die Ionen $Si^{4+}$, $Ge^{4+}$, $Ni^{3+}$, $Ti^{4+}$, $Co^{3+}$, $Co^{2+}$, $Cr^{3+}$, $Ga^{3+}$, $Mn^{3+}$, $Mn^{2+}$, $Hf^{4+}$, $Mg^{2+}$, $Zr^{4+}$, $Cu^{2+}$, $In^{3+}$, und $Ce^{4+}$ sowie binäre und ternäre Mischungen solcher Ionen eingesetzt werden. Die Radien dieser Ionen sind alle kleiner als der Ionenradius von Ytterbium bzw. Erbium auf dem Oktaederplatz. Der Einbau dieser Ionen in des Granatgitter bewirkt daher eine Kontraktion des Gitterplatzes. Beispiele für diese Art der Substitution sind in der nachfolgenden Tabelle 2 dargestellt.

TABELLE 2:
Substituenten für Aluminium

| Schmelzzusammensetzungen | Gitterkonstante (berechnet) [nm] |
|---|---|
| $\{La_{2,28}Yb_{0,72}\}[Yb_{1,9}Mg_{0,05}Si_{0,05}](Ga_3)O_{12}$ | 1,2907 |
| $\{La_2Y_1\}[Yb_{1,839}Cr_{0,161}](Ga_3)O_{12}$ | 1,2884 |
| $\{La_2Yb_1\}[Yb_{1,8}Al_{0,176}Cr_{0,024}](Ga_3)O_{12}$ | 1,2845 |
| $\{La_{2,096}Er_{0,904}\}[Yb_{1,839}Ga_{0,161}](Ga_3)O_{12}$ | 1,2888 |
| $\{La_2Y_1\}[Yb_{1,839}Ga_{0,161}](Ga_3)O_{12}$ | 1,2884 |
| $\{La_2Er_1\}[Yb_{1,8}Mg_{0,1}Zr_{0,1}](Ga_3)O_{12}$ | 1,2884 |
| $\{La_{2,28}Yb_{0,72}\}[Yb_{1,85}Mg_{0,075}Zr_{0,075}](Ga_3)O_{12}$ | 1,2913 |
| $\{La_{1,825}Tb_{1,175}\}[Yb_{1,73}Mg_{0,135}Zr_{0,135}](Ga_3)O_{12}$ | 1,2886 |
| $\{La_{1,95}Gd_{0,42}Yb_{0,63}\}[Yb_{1,6}Mg_{0,2}Zr_{0,2}](Ga_3)O_{12}$ | 1,2861 |
| $\{La_{1,95}Nd_{0,42}Yb_{0,63}\}[Yb_{1,6}Mg_{0,2}Zr_{0,2}](Ga_3)O_{12}$ | 1,2879 |
| $\{La_2Y_1\}[Yb_{1,46}Mg_{0,27}Zr_{0,27}](Ga_3)O_{12}$ | 1,2854 |
| $\{La_2Y_1\}[Yb_{1,675}Sc_{0,325}](Ga_3)O_{12}$ | 1,2884 |
| $\{La_2Y_1\}[Yb_{1,412}In_{0,588}](Ga_3)O_{12}$ | 1,2881 |
| $\{La_{1,76}Dy_{1,24}\}[Yb_{1,265}In_{0,735}](Ga_3)O_{12}$ | 1,2857 |
| $\{La_{1,8}Tb_{1,2}\}[Yb_{1,33}In_{0,67}](Ga_3)O_{12}$ | 1,2877 |
| $\{La_{1,3}Nd_1Ca_{0,1}Yb_{0,6}\}[Yb_{1,9}Ce_{0,1}](Ga_3)O_{12}$ | 1,2897 |
| $\{La_{2,3}Er_{0,7}\}[Er_2](Ga_3)O_{12}$ | 1,2965 |

Aus Schmelzen der beschreibenen Zusammensetzungen wurden Einkristalle nach dem bekannten Czochralski-Verfahren hergestellt. Als Ausführungsbeispiele werden im folgenden die Züchtung von fünf Granat-Einkristallen mit unterschiedlichen Gitterkonstanten $a_0$ beschrieben. Wietere Züchtungsbeispiele zusammen mit den Gitterkonstanten der Einkristalle sind in Tabelle 3 dargestellt.

TABELLE 3:
Chemische Zusammensetzung und Gitterkonstanten gezüchteter Kristalle

| Kristallzusammensetzung (Kristallanfang) | Gitterkonstante $a_o$ (Kristallanfang) [nm] |
|---|---|
| $La_{2,4}Yb_{2,61}Ga_3O_{12}$ | 1,2971* |
| $La_{2,28}Yb_{2,73}Ga_{2,99}O_{12}$ | 1,2972 |
| $La_{2,16}Yb_{2,80}Al_{0,08}Ga_{2,96}O_{12}$ | 1,2934 |
| $La_{1,86}Yb_{3,02}Al_{0,13}Cr_{0,03}Ga_{2,97}O_{12}$ | 1,2866 |
| $La_{2,16}Yb_{2,72}Mg_{0,05}Zr_{0,07}Ga_3O_{12}$ | 1,2936 |
| $La_{1,74}Y_{1,04}Yb_{2,05}Mg_{0,06}Zr_{0,06}Ga_{3,06}O_{12}$ | 1,2884 |
| $La_{1,89}Y_{1,01}Yb_{1,88}Mg_{0,11}Zr_{0,13}Ga_{2,97}O_{12}$ | 1,2899 |
| $La_{1,72}Y_{1,09}Yb_{1,82}Mg_{0,18}Zr_{0,18}Ga_{3,01}O_{12}$ | 1,2866 |
| $La_{1,75}Y_{1,02}Yb_{2,12}Ga_{3,11}O_{12}$ | 1,2876 |
| $La_{1,94}Er_{0,91}Yb_{2,09}Ga_{3,06}O_{12}$ | 1,2903 |
| $La_{2,28}In_{0,52}Yb_{2,22}Ga_{2,97}O_{12}$ | 1,2945 |
| $La_{2,15}Y_{0,61}Yb_{2,24}Ga_{3,01}O_{12}$ | 1,2945 |
| $La_{1,89}Y_{0,53}Yb_{2,51}Al_{0,07}Ga_3O_{12}$ | 1,2898 |
| $La_{1,09}Y_{0,91}Yb_{3,25}Al_{0,07}Ga_{2,69}O_{12}$ | 1,2819* |
| $La_{1,95}Er_{0,41}Yb_{2,55}Al_{0,06}Ga_3O_{12}$ | 1,2913 |
| $La_{1,88}Gd_{0,43}Yb_{2,61}Al_{0,07}Ga_3O_{12}$ | 1,2906 |
| $La_{1,40}Gd_{0,48}Yb_{2,96}Al_{0,09}Ga_{3,07}O_{12}$ | 1,2823 |
| $La_{1,90}Nd_{0,45}Yb_{2,60}Al_{0,09}Ga_{2,96}O_{12}$ | 1,2934 |
| $La_{0,8}Nd_{1,02}Yb_{2,95}Al_{0,17}Ga_{3,06}O_{12}$ | 1,2773 |
| $La_{1,25}Nd_1Yb_{2,69}Ga_{3,06}O_{12}$ | 1,2885 |
| $Pr_{2,15}La_{0,09}Yb_{2,67}Ga_{3,09}O_{12}$ | 1,2878* |
| $Pr_{1,61}Gd_{0,91}Yb_{2,28}Ga_{3,2}O_{12}$ | 1,2798 |
| $La_{1,45}Tb_{1,16}Yb_{2,05}Mg_{0,12}Zr_{0,13}Ga_{3,09}O_{12}$ | 1,2856 |
| $La_{1,49}Tb_{1,25}Yb_{1,55}In_{0,71}Ga_3O_{12}$ | 1,2793 |
| $La_{1,69}Dy_{1,28}Yb_{1,28}In_{0,73}Ga_{3,01}O_{12}$ | 1,2857* |
| $La_{1,09}Y_{0,91}Yb_{3,25}Al_{0,07}Ga_{2,96}O_{12}$ | 1,2793* |
| $La_{1,93}Eu_{0,43}Yb_{2,6}Al_{0,05}Ga_3O_{12}$ | 1,2915* |
| $La_{1,48}Y_{1,28}Yb_{2,11}Al_{0,08}Ga_{3,06}O_{12}$ | 1,2867* |
| $Pr_2Yb_{2,79}Al_{0,1}Ga_{3,12}O_{12}$ | 1,2799 |
| $La_2Er_{2,93}Ga_{3,07}O_{12}$ | 1,2965* |
| $Sm_{1,61}Yb_{2,70}Al_{0,29}Ga_{3,39}O_{12}$ | 1,2597 * |

* = berechnet

Beispiel I

Es wird die Züchtung eines Mischkristalls der Schmelzusammensetzung $Sm_2Yb_{2,75}Al_{0,25}Ga_3O_{12}$ beschrieben:

Die Ausgangssubstanzen (67,72 g $Sm_2O_3$, 105,22 g $Yb_2O_3$, 2,47 g $Al_2O_3$ und 54,59 g $Ga_2O_3$; Gesamteinwaage 230 g) werden gemischt, in Zylinderform trocken verpreßt und bei 1420°C in Sauerstoffatmosphäre gesintert.

Anschließend wird der Sinterkörper in einem induktiv beheizten Iridiumtiegel bei ca. 1800°C in einer abgeschlossenen Kristallziehapparatur aufgeschmolzen. Durch die Apparatur wird in Gemisch bestehend aus 50% $N_2$ und 50% $CO_2$ geleitet. Als Impfkristall dient ein zylinderförmiger Granatkristallstab. Der Ziehprozeß wird in bekannten Weise nach dem Czochralski-Verfahren durchgeführt. Die Wachstumgeschwindigkeit beträgt 2,00 mm/h, die Rotationsgeschwindigkeit ca. 40 $min^{-1}$. Die gezüchteten Kristalle haben eine maximale Länge von 50 mm und einen maximalen Durchmesser von 18 mm. Sie sind optisch transparent und haben eine gelbe Farbe. Ihre Gitterkonstante $a_0$ beträgt 1,2613 nm.

Beispiel II

Es wird die Züchtung eines Mischkristalls der Schmelzzusammensetzung $La_2Yb_{2,8}Al_{0,176}Cr_{0,024}Ga_3O_{12}$ beschrieben:

Die Ausgangssubstanzen (64,08 g $La_2O_3$, 108,50 g $Yb_2O_3$, 1,765 g $Al_2O_3$, 0,359 g $Cr_2O_3$ und 55,29 g $Ga_2O_3$; Gesamteinwaage 230 g) werden gemischt, in Zylinderform trocken verpreßt und bei 1420°C in Sauerstoffatmosphäre gesintert.

Anschließend wird der Sinterkörper in einem induktiv beheizten Iridiumtiegel bei ca. 1800°C in einer abgeschlossenen Kristallziehapparatur aufgeschmolzen. Durch die Apparatur wird ein Gasgemisch bestehend aus 50% $N_2$ und 50% $CO_2$ geleitet. Als Impfkristall dient ein zylinderförmiger Granateinkristallstab. Der Ziehprozeß wird in bekannter Weise nach dem Czochralski-Verfahren durchgeführt. Die Wachstumgeschwindigkeit beträgt 2,00 mm/h, die Rotationsgeschwindigkeit ca. 50 $min^{-1}$. Die gezüchteten Kristalle haben eine maximale Länge von 60 mm und einen maximalen Durchmesser von 18 mm. Sie sind optisch transparent und haben eine dunkelgrüne Farbe. Ihre Gitterkonstante $a_0$ beträgt 1,2868 nm, wobei die Abweichung $\Delta a_0$ des Wertes für die Gitterkonstante zwischen Wachstumgsbeginn und Wachstumsende nicht mehr als $4 \times 10^{-4}$ nm beträgt.

Beispiel III

Es wird die Züchtung eines Mischkristalls der Schmelzzusammensetzung $La_{2,096}Er_{0,904}Yb_{1,839}Ga_{3,161}O_{12}$ beschrieben:

Die Ausgangssubstanzen (218,33 g $La_2O_3$, 110,55 g $Er_2O_3$, 231,69 g $Yb_2O_3$ und 189,42 g $Ga_2O_3$; Gesamteinwaage 750 g) werden gemischt, in Zylinderform trocken verpreßt und bei 1420°C in Sauerstoffatmosphäre gesintert.

Anschließend wird der Sinterkörper in einem induktiv beheizten Iridiumtiegel bei ca. 1800°C in einer abgeschlossenen Kristallziehapparatur aufgeschmolzen. Durch die Apparatur wird ein Gasgemisch bestehend aus 98% $N_2$ und 2% $O_2$ geleitet. Als Impfkristall dient ein zylinderförmiger Granateinkristallstab. Der Ziehprozeß wird in bekannter Weise nach dem Czochralski-Verfahren durchgeführt. Die Wachstumsgeschwindigkeit beträgt 2,00 m/h, die Rotationsgeschwindigkeit ca. 40 $min^{-1}$. Die gezüchteten Kristalle haben eine maximale Länge von 55 mm und einen maximalen Durchmesser von 31 mm. Sie sind optisch transparent und haben eine rosa Farbe. Ihre Gitterkonstante $a_0$ beträgt 1,2907 nm, wobei die Abweichung $\Delta a_0$ des Wertes für die Gitterkonstante zwischen Wachstumgsbeginn und Wachstumsende nicht mehr als $8 \times 10^{-4}$ nm beträgt.

Beispiel IV

Es wird die Züchtung eines Mischkristalls der Schmelzzusammensetzung $La_{2,17}Nd_{0,42}Yb_{2,31}Al_{0,1}Ga_3O_{12}$ beschrieben:

Die Ausgangssubstanzen (69,76 g $La_2O_3$, 13,94 g $Nd_2O_3$, 89,81 g $Yb_2O_3$, 1,01 g $Al_2O_3$ und 55,48 g $Ga_2O_3$; Gesamteinwaage 230 g) werden gemischt, in Zylinderform trocken verpreßt und bei 1420°C in Sauerstoffatmosphäre gesintert.

Anschließend wird der Sinterkörper in einem induktiv beheizten Iridiumtiegel bei ca. 1800°C in einer abgeschlossenen Kristallziehapparatur aufgeschmolzen. Durch die Apparatur wird ein Gasgemisch bestehend aus 50% $N_2$ und 50% $CO_2$ geleitet. Als Impfkristall dient ein zylinderförmiger Granateinkristallstab.

Der Ziehprozeß wird in bekannter Weise nach dem Czochralski-Verfahren durchgeführt. Die Wachstumsgeschwindigkeit wurde im Bereich von 2,00 m/h bis 6,00 mm/h variiert, die Rotationsgeschwindigkeit betrug ca. 45 $min^{-1}$. Die gezüchteten Kristalle haben eine maximale Länge von 63 mm und einen maximalen Durchmesser von 18 mm. Sie sind optisch transparent und haben je nach Art der Lichtquelle eine dunkelviolette oder dunkelgründe Farbe. Ihre Gitterkonstante $a_0$ beträgt 1,2938 nm, wobei die Abweichung $\Delta a_0$ des Wertes für die Gitterkonstante zwischen Wachstumsbeginn und Wachstumsende nicht mehr als $8 \times 10^{-4}$ nm beträgt.

Beispiel V

Es wird die Züchtung eines Mischkristalls der Schmelzusammensetzung $La_{2,3}Er_{2,7}Ga_3O_{12}$ beschrieben:

Die Ausgangssubstanzen (73,52 g $La_2O_3$, 101,32 g $Er_2O_3$ und 55,16 g $Ga_2O_3$; Gesamteinwaage 230 g) werden gemischt, in Zylinderform trocken verpreßt und bei 1420°C in Sauerstoffatmosphäre gesintert.

Anschließend wird der Sinterkörper in einem induktiv beheizten Iridiumtiegel bei ca. 1800°C in einer abgeschlossenen Kristallziehapparatur aufgeschmolzen. Durch die Apparatur wird ein Gasgemisch bestehend aus 50% $N_2$ und 50% $CO_2$ geleitet. Als Impfkristall dient ein zylinderförmiger Granateinkristallstab.

Der Ziehprozeß wird in bekannter Weise nach dem Czochralski-Verfahren durchgeführt. Die Wachstumsgeschwindigkeit beträgt 2,00 mm/h, die Rotationsgeschwindigkeit ca. 30 $min^{-1}$. Die gezüchteten Kristalle haben eine maximale Länge von 53 mm und einen maximalen Durchmesser von 18 mm. Sie sind optisch transparent und haben eine rosa Farbe. Ihre Gitterkonstante $a_0$ beträgt 1,2965 nm.

Die in den Ausführungsbeispielen I bis V angegebenen Werte für die Gitterkonstante $a_0$ entsprechen Mittelwerten aus den Werten für $a_0$ an Kristallanfang und Kristallende.

Die Abmessungen der gezüchteten Kristalle gemäß den Ausführungsbeispielen I, II, IV und V zeigen kleinere Werte als die gemäß Ausführungsbeispiel III; dies ist auf die geringere Menge an Ausgangssubstanz für die Schmelze gemäß den Ausführungsbeispielen I, II, IV und V gegenüber dem Ausführungsbeispiel II zurückzuführen.

**Patentansprüche**

1. Einkristall auf Basis von Selternerdmetall-Gallium-Granat, ausgenommen

$$\{La_{2,6}Yb_{0,4}\}[Yb_2](Ga_3)O_{12},$$

dadurch gekennzeichnet, daß der Einkristall ein Mischkristall der allgemeinen Formel $A_{3-x-y}B_xC_yD_{2-z}E_zGa_3O_{12}$ ist, worin
A=$La^{3+}$, $Pr^{3+}$, $Nd^{3+}$, $Sm^{3+}$ und/oder $Eu^{3+}$
B=$Yb^{3+}$, $Er^{3+}$ und/oder $Y^{3+}$
C=$Er^{3+}$, $Ho^{3+}$, $Y^{3+}$, $Dy^{3+}$, $Tb^{3+}$, $Gd^{3+}$, $Eu^{3+}$, $Sm^{3+}$, $Nd^{3+}$, $Ca^{2+}$, $Pr^{3+}$, $Ce^{3+}$, $Sr^{2+}$ und/oder binäre Mischungen dieser Ionen
D=$Yb^{3+}$, $Er^{3+}$
E=$Si^{4+}$, $Ge^{4+}$, $Al^{3+}$, $Ni^{3+}$, $Ti^{4+}$, $Co^{3+}$, $Cr^{3+}$, $Ga^{3+}$, $Mn^{3+}$, $Hf^{4+}$, $Mg^{2+}$, $Zr^{4+}$, $Cu^{2+}$, $Sc^{3+}$, $Co^{2+}$, $In^{3+}$, $Mn^{2+}$, $Lu^{3+}$, $Ce^{4+}$ und/oder binäre Mischungen dieser Ionen
mit $0 \leq x \leq 2,0$
$0 \leq y \leq 1,8$
$0 \leq z \leq 0,4$.

4. Einkristall nach Anspruch 1, dadurch gekennzeichnet, daß seine Schmelzzusammensetzung der Formel

$$La_{2,096}Er_{0,904}Yb_{1,839}Ga_{3,161}O_{12}$$

entspricht.

5. Einkristall nach Anspruch 1, dadurch gekennzeichnet, daß seine Schmelzzusammensetzung der Formel

$$La_{2,17}Nd_{0,42}Yb_{2,31}Al_{0,1}Ga_3O_{12}$$

entspricht.

6. Einkristall nach Anspruch 1, dadurch gekennzeichnet, daß seine Schmelzzusamensetzung der Formel

$$La_{2,3}Er_{2,7}Ga_3O_{12}$$

entspricht.

7. Verfahren zur Herstellung eines Einkristalls nach den Ansprüchen 1 bis 6, dadurch gekennzeichnet, daß die Ausgangssubstanzen für den Einkristall zunächst trocken verpreßt und in einer Sauerstoffatmosphäre gesintert werden, daß der Sinterkörper zur Herstellung eines Einkristalls nach dem Czochralski-Verfahren in einer abgeschlossenen Kristallziehapparatur aufgeschmolzen und daß aus dieser Schmelze ein Einkrstall mit Hilfe eines Keimkristalls gezogen wird.

8. Verfahren nach Anspruch 7, dadurch gekennzeichnet, daß der Einkristall unter einer Gasatmosphäre bestehend aus 50% $N_2$ und 50% $CO_2$ gezogen wird.

9. Verfahren nach Anspruch 7, dadurch gekennzeichnet, daß der Einkristall unter einer Gasatmosphäre bestehend aus 98% $N_2$ und 2% $O_2$ gezogen wird.

10. Verwendung des Einkristalls nach einem der Ansprüche 1 bis 6 als Wirtgitter für den Einbau von Fremdatomen, die einen Lasereffekt zeigen.

11. Verwendung des Einkristalls nach einem der Ansprüche 1 bis 6 als Substrat für epitaktische Schichten, die als Infrarotdetektoren eingesetzt werden.

**Revendications**

1. Monocristal à base de grenat de gallium-métal des terres rares, à l'exception de $\{La_{2,6}Yb_{0,4}\}[Yb_2](Ga_3)O_{12}$, caractérisé en ce que le monocristal est un cristal mixte répondant à la formule générale
$A_{3-x-y}B_xC_yD_{2-z}E_zGa_3O_{12}$, dans laquelle
A=$La^{3+}$, $Pr^{3+}$, $Nd^{3+}$, $Sm^{3+}$ et/ou $Eu^{3+}$
B=$Yb^{3+}$, $Er^{3+}$ et/ou $Y^{3+}$
C=$Er^{3+}$, $Ho^{3+}$, $Y^{3+}$, $Dy^{3+}$, $Tb^{3+}$, $Gd^{3+}$, $Eu^{3+}$, $Sm^{3+}$, $Nd^{3+}$, $Ca^{2+}$, $Pr^{3+}$, $Ce^{3+}$, $Sr^{2+}$ et/ou des mélanges binaires de ces ions
D=$Yb^{3+}$, $Er^{3+}$
E=$Si^{4+}$, $Ge^{4+}$, $Al^{3+}$, $Ni^{3+}$, $Ti^{4+}$, $Co^{3+}$, $Cr^{3+}$, $Ga^{3+}$, $Mn^{3+}$, $Hf^{4+}$, $Mg^{2+}$, $Zr^{4+}$, $Cu^{2+}$, $Sc^{3+}$, $Co^{2+}$, $In^{3+}$, $Mn^{2+}$, $Lu^{3+}$, $Ce^{4+}$ et/ou des mélanges binaires de ces ions.
avec $0 \leq x \leq 2,0$
$0 \leq y \leq 1,8$
$0 \leq z \leq 0,4$.

2. Monocristal selon la revendication 1, caractérisé en ce que sa composition de bain répond à la formule

$$Sm_2Yb_{2,75}Al_{0,25}Ga_3O_{12}.$$

3. Monocristal selon la revendication 1, caractérisé en ce que sa composition de bain répond à la formule

$$La_2Yb_{2,8}Al_{0,176}Cr_{0,024}Ga_3O_{12}.$$

4. Monocristal selon la revendication 1, caractérisé en ce que sa composition de bain répond à la formule

$$La_{2,096}Er_{0,904}Yb_{1,839}Ga_{3,161}O_{12}.$$

5. Monocristal selon la revendication 1, caractérisé en ce que sa composition de bain répond à la formule

$$La_{2,17}Nd_{0,42}Yb_{2,31}Al_{0,1}Ga_3O_{12}.$$

6. Monocristal selon la revendication 1, caractérisé en ce que sa composition de bain répond à la formule

$$La_{2,3}Er_{2,7}Ga_3O_{12}.$$

7. Procédé pour la réalisation d'un monocristal selon la revendication 1 à 6, caractérisé en ce que les substances de départ pour le monocristal sont d'abord pressées à l'état sec et frittées dans une atmosphère d'oxygène, en ce que le corps fritté pour la réalisation d'un monocristal selon le procédé Czochralski et fondu dans un appareil à étirage de cristaux fermé et en ce qu'à partir de ce bain est étiré un monocristal à l'aide d'un germe cristallin.

8. Procédé selon la revendication 7, caractérisé en ce que le monocristal est étiré dans une atmosphère gazeuse constituée par 50% de $N_2$ et 50% de $CO_2$.

9. Procédé selon la revendication 7, caractérisé en ce que le monocristal est étiré dans une atmosphère gazeuse constituée par 98% de $N_2$ et 2% d'$O_2$.

10. Application du monocristal selon l'une des revendications 1 à 6, comme réseau de base pour l'incorporation d'atomes étrangers présentant un effet laser.

11. Application du monocristal selon l'une des revendications 1 à 6 comme substrat pour des couches épitaxiales utilisées comme détecteurs infra-rouges.

## Claims

1. A single crystal on the basis of rare earth metal-gallium garnet, with the exception of $\{La_{2.6}Yb_{0.4}\}[Yb_2](Ga_3)O_{12}$, characterized in that the single crystal is a mixed crystal of the general formula $A_{3-x-y}B_xC_yD_{2-z}E_zGa_3O_{12}$, wherein

A=$La^{3+}$, $Pr^{3+}$, $Nd^{3+}$, $Sm^{3+}$ and/or $Eu^{3+}$

B=$Yb^{3+}$, $Er^{3+}$, and/or $Y^{3+}$

C=$Er^{3+}$, $Ho^{3+}$, $Y^{3+}$, $Dy^{3+}$, $Tb^{3+}$, $Gd^{3+}$, $Eu^{3+}$, $Sm^{3+}$, $Nd^{3+}$, $Ca^{2+}$, $Pr^{3+}$, $Ce^{3+}$, $Sr^{2+}$ and/or binary mixtures of these ions

D=$Yb^{3+}$, $Er^{3+}$

E=$Si^{4+}$, $Ge^{4+}$, $Al^{3+}$, $Ni^{3+}$, $Ti^{4+}$, $Co^{3+}$, $Cr^{3+}$, $Ga^{3+}$, $Mn^{3+}$, $Hf^{4+}$, $Mg^{2+}$, $Zr^{4+}$, $Cu^{2+}$, $Sc^{2+}$, $Co^{2+}$, $In^{3+}$, $Mn^{2+}$, $Lu^{3+}$, $Ce^{4+}$ and/or binary mixtures of these ions

with $0 \leq x \leq 2.0$

$0 \leq y \leq 1.8$

$0 \leq z \leq 0.4$

2. A single crystal as claimed in Claim 1, characterized in that its melt composition corresponds to the formula

$$Sm_2Yb_{215}Al_{0.25}Ga_3O_{12}.$$

3. A single crystal as claimed in Claim 1 characterized in that its melt composition corresponds to the formula

$$La_2Yb_{2.8}Al_{0.176}Cr_{0.024}Ga_3O_{12}.$$

4. A single crystal as claimed in Claim 1, characterized in that its melt composition corresponds to the formula

$$La_{2.096}Er_{0.904}Yb_{1.839}Ga_{3.161}O_{12}.$$

5. A single crystal as claimed in Claim 1, characterized in that its melt composition corresponds to the formula

$$La_{2.17}Nd_{0.42}Yb_{2.31}Al_{0.1}Ga_{3}O_{12}.$$

6. A single crystal as claimed in Claim 1, characterized in that its melt composition corresponds to the formula $La_{2.3}Er_{2.7}Ga_{3}O_{12}$.

7. A method of manufacturing a single crystal as claimed in Claims 1—6, characterized in that the starting substances for the single crystal are first compressed in the dry state and sintered in an oxygen atmosphere, that the sintered body for the manufacture of a single crystal according to the Czochralski method is melted in a closed crystal drawing apparatus, and the a single crystal is drawn from said melt by means of a seed crystal.

8. A method as claimed in Claim 7, characterized in that the single crystal is drawn under a gas atmosphere consisting of 50% $N_2$ and 50% $CO_2$.

9. A method as claimed in Claim 7, characterized in that the single crystal is drawn under a gas atmosphere consisting of 98% $N_2$ and 2% $O_2$.

10. The use of the single crystal as claimed in any of the Claims 1—6 as a host lattice for the incorporation of foreign atoms which show a laser effect.

11. The use of the single crystal as claimed in any of the Claims 1—6 as a substrate for epitaxial layers which are used as infrared detectors.

$\{La_{3-x-y}\ Yb_x\ Er_y\}\ [Yb_{2-z}\ Al_z]\ (Ga_3)\ O_{12}$

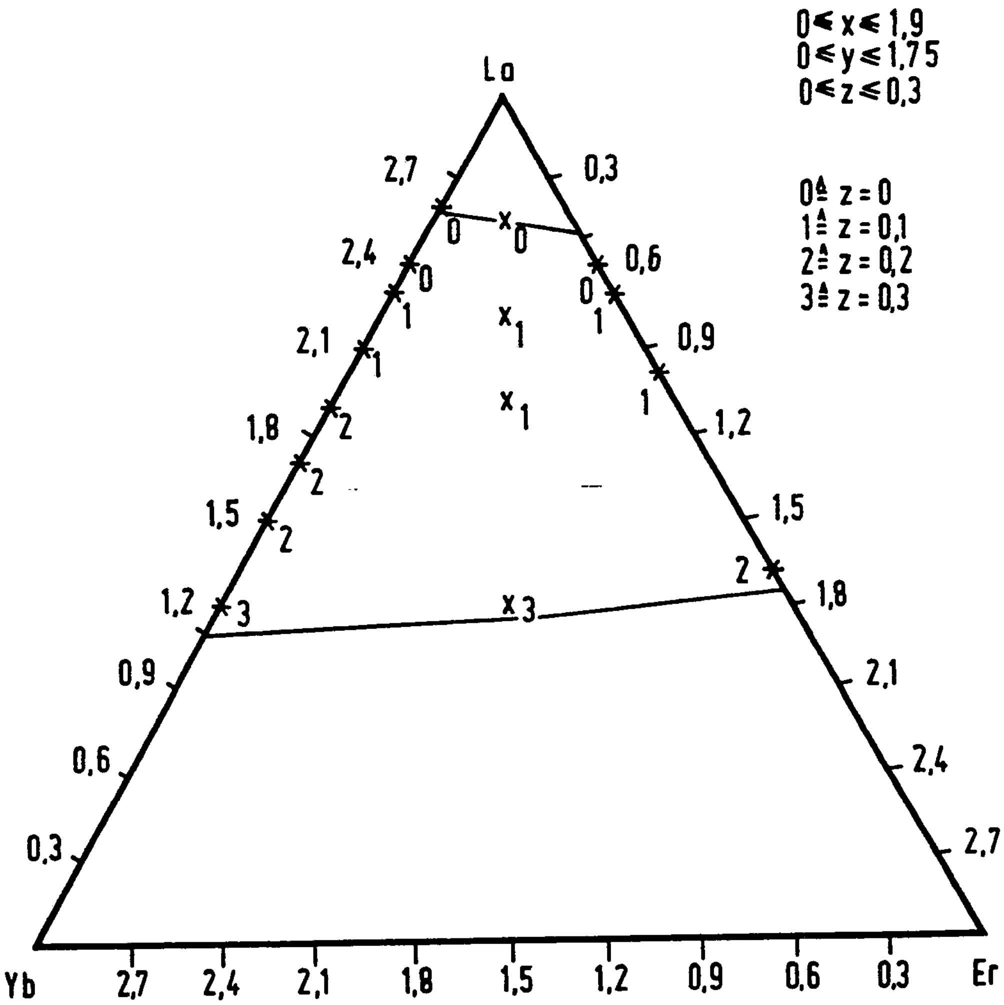


$\{La_{3-x-y}\ Yb_x\ Er_y\}\ [Yb_{2-z}\ Al_z]\ (Ga_3)\ O_{12}$

FIG. 1

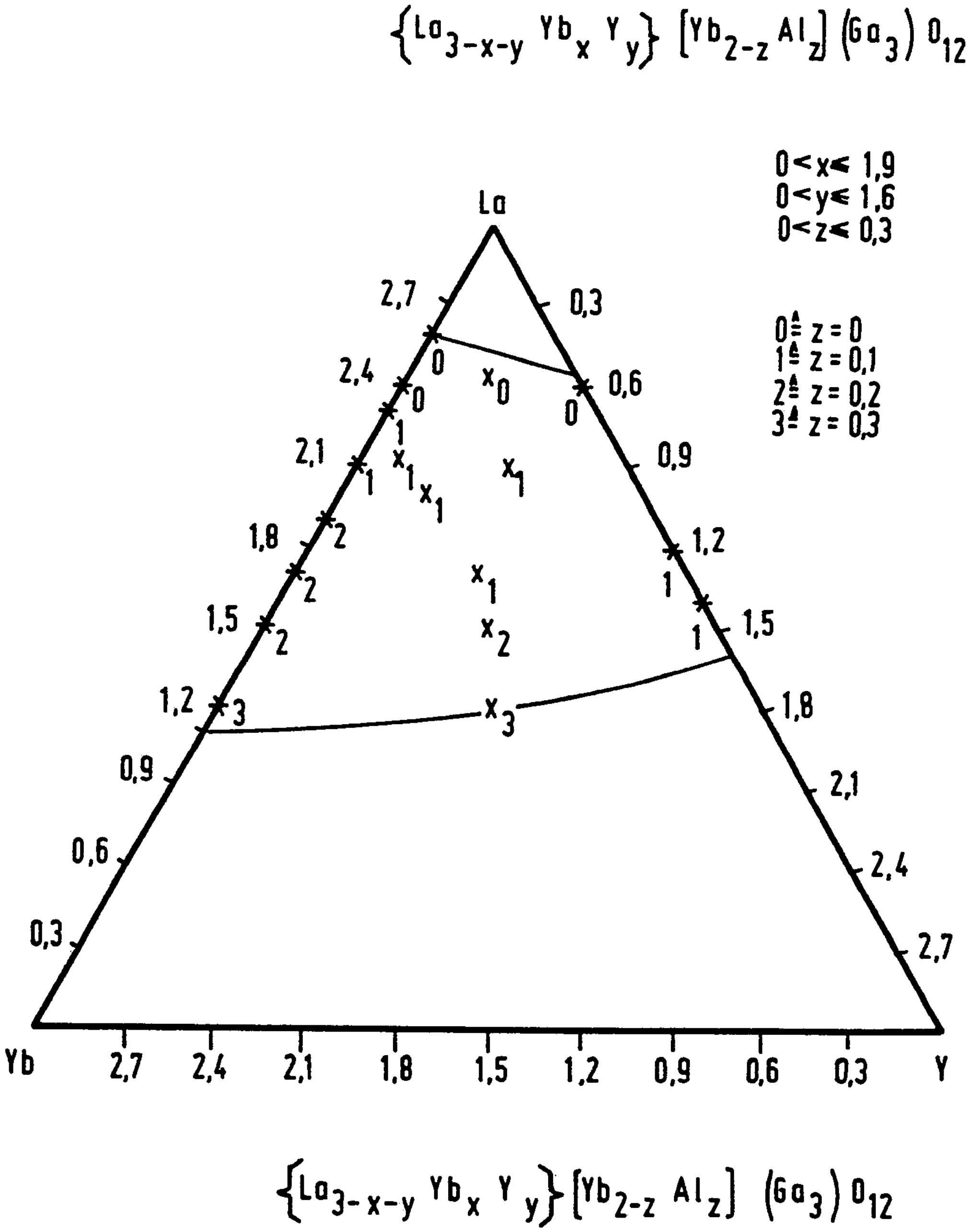
{La3-x-y Ybx Yy} [Yb2-z Alz] (Ga3) O12
0<x≤ 1,9
0<y≤ 1,6
0<z≤ 0,3
0 ≙ z = 0
1 ≙ z = 0,1
2 ≙ z = 0,2
3 ≙ z = 0,3
La
Yb
Y
2,7
2,4
2,1
1,8
1,5
1,2
0,9
0,6
0,3
{La3-x-y Ybx Yy} [Yb2-z Alz] (Ga3) O12

FIG. 2

$\{La_{3-x-y}Yb_xGd_y\}[Yb_{2-z}Al_z](Ga_3)O_{12}$

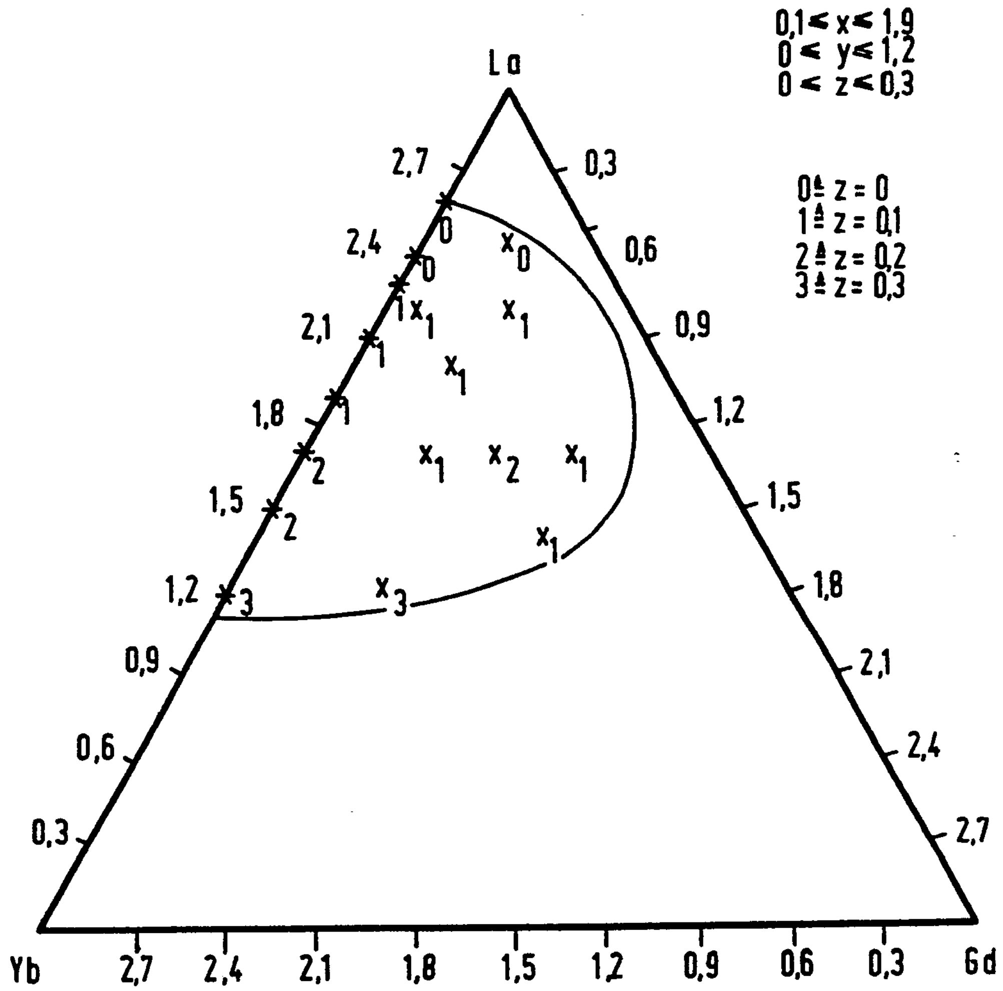


$\{La_{3-x-y}Yb_xGd_y\}[Yb_{2-z}Al_z](Ga_3)O_{12}$

FIG. 3

$\{La_{3-x-y}\,Yb_x\,Nd_y\}\,[Yb_{2-z}\,Al_z]\,(Ga_3)\,O_{12}$

$0{,}4 \leq x \leq 1{,}9$
$0 \leq y \leq 1{,}4$
$0 \leq z \leq 0{,}3$

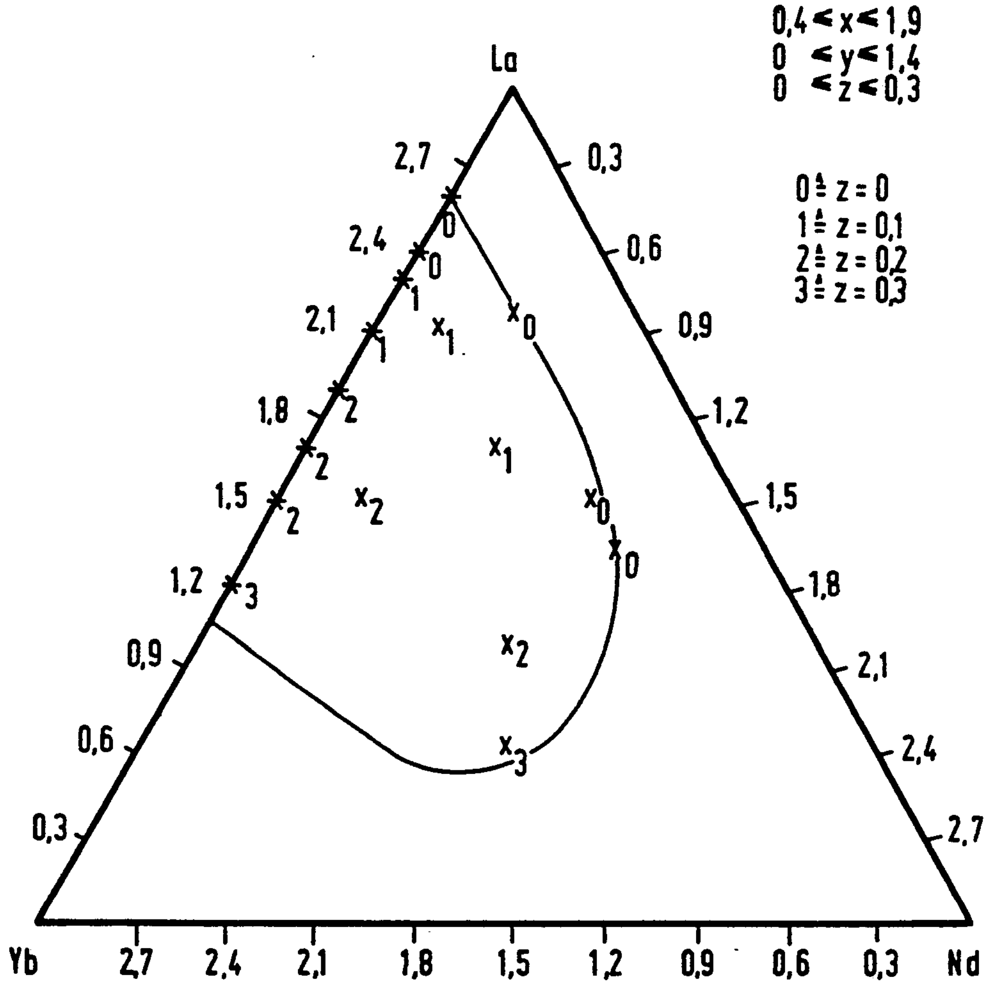


$\{La_{3-x-y}\,Yb_x\,Nd_y\}\,[Yb_{2-z}\,Al_z]\,(Ga_3)\,O_{12}$

FIG. 4